# EUROPEAN PATENT APPLICATION

(11) **EP 4 807 768 A1**
(43) Date of publication of application: **16.09.2026**
(21) Application number: 25225191.3
(22) Date of filing: 18.12.2025
(51) Int. Cl.: H01F 3/04, H01F 27/25, H01F 27/30, H02M 3/00, H05K 7/14

(54) **SYSTEMS AND METHODS FOR MAGNETIC SHEET INTEGRATION IN BUSBAR STRUCTURES FOR VEHICLE**

(30) Priority: 12.03.2025 US 202563770478 P; 12.12.2025 US 202519416128
(71) Applicant: Borgwarner Inc., Auburn Hills, Michigan 48326 (US)
(72) Inventor: MURTHY, Vikram, Carmel, IN (US)
(74) Representative: Office Freylinger

(57) **Abstract**

A system includes a power converter, the power converter including: a direct current (DC) busbar including: a first magnetic layer; a second magnetic layer; a third magnetic layer; a first direct current connector between the first magnetic layer and the second magnetic layer; and a second direct current connector between the second magnetic layer and the third magnetic layer.

## Description

### TECHNICAL FIELD

Various embodiments of the present disclosure relate generally to systems and methods for magnetic sheet integration in busbar structures and, more particularly, to systems and methods for magnetic sheet integration in busbar structures for reducing common mode currents in electric vehicle power systems.

### BACKGROUND

High dV/dt switching electronic devices, such as inverters, may generate common mode currents. Common mode currents, driven by parasitic capacitances, may flow through the chassis of the system, cause electromagnetic interference (EMI) issues, and induce parasitic currents in the motor bearing system. Common mode chokes are frequently used to limit the common mode currents within inverters. However, common mode filters are large and take up packaging volume in high DC current applications.

The present disclosure is directed to overcoming one or more of these above-referenced challenges.

### SUMMARY OF THE DISCLOSURE

In some aspects, the techniques described herein relate to a system including a power converter, the power converter including: a direct current (DC) busbar including: a first magnetic layer; a second magnetic layer; a third magnetic layer; a first direct current connector between the first magnetic layer and the second magnetic layer; and a second direct current connector between the second magnetic layer and the third magnetic layer.

In some aspects, the techniques described herein relate to a system, wherein the DC busbar is a high voltage DC busbar.

In some aspects, the techniques described herein relate to a system, wherein the first magnetic layer and the third magnetic layer are wrapped around the first direct current connector and the second direct current connector.

In some aspects, the techniques described herein relate to a system, wherein the first direct current connector is a positive direct current connector and the second direct current connector is a negative direct current connector.

In some aspects, the techniques described herein relate to a system, wherein one or more of the first magnetic layer, the second magnetic layer, or the third magnetic layer includes an adhesive material.

In some aspects, the techniques described herein relate to a system, wherein one or more of the first magnetic layer, the second magnetic layer, or the third magnetic layer is configured to attenuate high frequency currents from one or more of the first direct current connector or the second direct current connector.

In some aspects, the techniques described herein relate to a system, wherein the DC busbar includes a flexible busbar.

In some aspects, the techniques described herein relate to a system, wherein one or more of the first magnetic layer, the second magnetic layer, or the third magnetic layer includes a ferrite material.

In some aspects, the techniques described herein relate to a system, wherein the DC busbar includes a modular DC busbar.

In some aspects, the techniques described herein relate to a system, further including: a battery; and a motor connected to one or more of the motor or the power converter, wherein the battery, the motor, and the power converter are provided as a vehicle.

In some aspects, the techniques described herein relate to a busbar stack including: a first magnetic layer; a second magnetic layer; a third magnetic layer; a fourth magnetic layer; a fifth magnetic layer; a first direct current connector between the first magnetic layer and the second magnetic layer; a second direct current connector between the second magnetic layer and the third magnetic layer; a third direct current connector between the third magnetic layer and the fourth magnetic layer; and a fourth direct current connector between the fourth magnetic layer and the fifth magnetic layer.

In some aspects, the techniques described herein relate to a busbar stack, wherein one or more of the first magnetic layer, the second magnetic layer, the third magnetic layer, the fourth magnetic layer, or the fifth magnetic layer includes a nanocrystalline structure.

In some aspects, the techniques described herein relate to a busbar stack, wherein one or more of the first magnetic layer, the second magnetic layer, the third magnetic layer, the fourth magnetic layer, or the fifth magnetic layer includes a ferrite material.

In some aspects, the techniques described herein relate to a busbar stack, wherein one or more of the first magnetic layer, the second magnetic layer, the third magnetic layer, the fourth magnetic layer, the fifth magnetic layer, the first direct current connector, the second direct current connector, the third direct current connector, or the fourth direct current connector is attached to an adjacent structure by one or more adhesives.

In some aspects, the techniques described herein relate to a busbar stack, wherein the busbar stack is configured for one or more of common mode filtering or differential mode filtering.

In some aspects, the techniques described herein relate to a busbar including: a first magnetic layer; a second magnetic layer; a first direct current connector between the first magnetic layer and the second magnetic layer; and a second direct current connector between the first magnetic layer and the second magnetic layer.

In some aspects, the techniques described herein relate to a busbar, further including: a third direct current connector between the first magnetic layer and the second magnetic layer; and a fourth direct current connector between the first magnetic layer and the second magnetic layer.

In some aspects, the techniques described herein relate to a busbar, further including: a third magnetic layer between the first direct current connector and the second direct current connector.

In some aspects, the techniques described herein relate to a busbar, wherein the first magnetic layer is attached to the first direct current connector with an adhesive.

In some aspects, the techniques described herein relate to a busbar, wherein the first magnetic layer is configured to shield the first direct current connector.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a power converter, according to one or more embodiments.
FIG. 2 depicts an exemplary system infrastructure for a power converter, according to one or more embodiments.
FIG. 3 depicts an exemplary system infrastructure for a controller, according to one or more embodiments.
FIG. 4 depicts an exemplary busbar structure, according to one or more embodiments.
FIG. 5 depicts an exemplary interleaved DC link bus structure, according to one or more embodiments.
FIG. 6 depicts an exemplary interleaved bus structure, according to one or more embodiments.
FIG. 7 depicts an exemplary magnetic shielding sheet, according to one or more embodiments.
FIG. 8 depicts an exemplary composite structure, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to systems and methods for magnetic sheet integration in busbar structures and, more particularly, to systems and methods for magnetic sheet integration in busbar structures for reducing common mode currents in electric vehicle power systems.

Inverters, such as those used to drive a motor in an electric vehicle, for example, are responsible for converting High Voltage Direct Current (HVDC) into Alternating Current (AC) to drive the motor. A three phase inverter may include a bridge with six power device switches (for example, power transistors such as IGBT or MOSFET) that are controlled by Pulse Width Modulation (PWM) signals generated by a controller. An inverter may include three half-H bridge switches to control the phase voltage, upper and lower gate drivers to control the switches, a PWM controller, and glue logic between the PWM controller and the gate drivers. The PWM controller may generate signals to define the intended states of the system. The gate drivers may send the signals from the PWM controller to the half-H bridge switches. The half-H bridge switches may drive the phase voltage. Six phase (or other phase) inverters, chargers, DC-DC converters, and/or multi-level inverters are not excluded from this concept and will follow similar principles. The present disclosure refers to an inverter as an example embodiment of a power converter. Power converters may include chargers, inverters, or DC-DC converters, for example.

Electric vehicles, energy storage systems, and backup generators, for example, convert electric power from one form to another. Additionally, an on-board charger for a vehicle, for example, may have a dual purpose. The on-board charger may be a bi-directional system that converts AC voltage to DC voltage in a charging mode (grid-to-battery) and DC voltage to AC voltage in a discharge or inverter mode (battery-to-grid). The charging mode may convert the grid AC into DC voltage to charge the vehicle high voltage (HV) battery, and the discharge or inverter mode may convert the HV battery DC voltage into AC voltage that may be supplied to a load of the grid line voltage, be supplied as a backup generator to power a house when the grid is down, or as an inverter to supply voltage to vehicle AC outlets, for example.

High dv/dt systems such as traction inverters may have common mode current problems, where the currents flow through the chassis of the system after coupling through parasitic capacitances. The common mode currents may cause EMI issues, as well as bearing currents through the electric motor. Common mode chokes are frequently used to limit the common mode currents, and are used in traction inverters. The use of magnetic materials to create the inductance are common in the industry. The parasitic capacitances are often found within the electric motor from the windings to the chassis of the system. The return path of the common mode currents is through the inverter and through the vehicle chassis.

Some busbars in power electronic products carry high currents, and require thick busbars. Thinner copper sheets may be used to carry high currents and reduce creepage and clearance distances than standard busbars. Thinner copper sheets also allows for interleaving the HV+ and HV- busbars together to decrease the loop area of the HV system. Ferrite sheets may be used in wireless charger applications as a way to reduce radiated emissions in systems.

Common mode chokes are challenging to implement, due to their large size. The volume of common mode chokes often cause vibration issues and manufacturing issues. It is challenging to increase the inductance in traction inverters, due to the high DC current and the use of busbars to carry current. It is impractical to implement multiple turns in the system to increase common mode inductance.

The issues are well known, and have been solved with clamps to keep the core together, and the use of glue. There are also single piece cores, and those are challenging to manufacture in a system, because the core must slide over complex busbar assemblies. Many systems have taken this out of the design, due to cost and implementation challenges, but still face challenges associated with common mode currents. A grounding ring on the motor shaft and/or the use of ceramic bearings can also reduce the common mode currents.

The problems associated with common mode currents may be solved by the use of ferrite sheets in conjunction with modular busbar solutions. The ability to layer and interleave the magnetic material within the bus structure may allow for decreasing the loop area and provide more inductance to reduce the common mode currents in the system. More surface area of the bus structure can be covered by magnetic material which may provide more attenuation. High frequency currents may be attenuated by the magnetic material, leading to better EMI performance and less high frequency currents.

Each of the layer may represent multiple layers of material to increase the inductance. The same methodology may be used on three phase outputs of motors as well. The HVDC busbars may be arranged in a traditional stackup, with a layer of magnetic material in between. The material may be placed with an interleaved bus structure and the magnetic material interleaved in between for both common mode and differential mode filtering. An interleaved bus structure may have magnetic material around the busbars.

This differs from some systems in the fact that it does not require a complex busbar sub assembly to fit the ferrite core. One or more embodiments may utilize a flexible bus structure, instead of the traditional busbars in an inverter. Multiple layers of magnetic material may be used, and may be used between busbar layers. Some methods may use a complex process that includes cleaning, sputtering, electroplating, masking, etching, and cutting. One or more embodiments may use adhesive technology so that the assembly process is significantly simplified. One or more embodiments may provide interleaving of busbar structures as a part of the filtering.

One or more embodiments may provide simpler busbar routing, as well as decreased inverter volume since a large choke will not be needed. One or more embodiments may provide a simpler mechanical implementation since vibration would be less of an issue. One or more embodiments may use adhesive instead of needing to use a sub assembly with a clamp. One or more embodiments may use ferrite material that can act as a shield as well, since it would attenuate radiated emissions coming from the busbar. Common mode currents may be reduced closer to the switches, where the noise is generated. One or more embodiments may place ferrite material close to the AC busbars as well and through the motor, which will reduce the need for ceramic bearings or a method to ground the shaft. Increased filtering of common mode noise can be attenuated by the introduction of magnetic materials surrounding the busbar filtration as a single winding common mode choke.

One or more embodiments of the disclosure may provide a busbar structure with integrated magnetic filtering that reduces common mode currents without requiring bulky external common mode chokes. Some approaches for addressing common mode currents in electric vehicle power systems may use discrete common mode chokes that are positioned externally to the busbar assembly. These approaches may require complex mechanical assemblies where ferrite cores must be fitted around existing busbar structures, often requiring the core to slide over complex busbar assemblies during manufacturing. These approaches may result in large volume requirements, mechanical vibration issues, and manufacturing challenges due to the need for clamps and adhesives to secure the ferrite cores. Some approaches may require complex fabrication processes including cleaning, sputtering, electroplating, masking, etching, and cutting to integrate magnetic materials with bus structures. These approaches may not effectively address common mode currents at their source near the switching devices, and may not provide adequate surface area coverage of the bus structure for optimal electromagnetic interference attenuation.

One or more embodiments may solve the problem of common mode current generation and electromagnetic interference by integrating flexible magnetic sheet materials directly into modular busbar structures using adhesive attachment methods. One or more embodiments may provide magnetic sheet materials, such as ferrite or nanocrystalline materials, which can be applied as adhesive layers to busbar structures. The magnetic materials may be configured in multiple arrangements including interleaved configurations between positive and negative busbar layers, wrapped configurations around the exterior of busbar assemblies, or combinations of both interleaved and wrapped configurations. The flexible nature of the magnetic sheet materials may allow for conforming to complex busbar geometries while providing electromagnetic filtering functionality.

One or more embodiments may reduce the loop area for common mode currents by interleaving magnetic materials between alternating positive and negative busbar layers. The interleaved arrangement may provide both common mode filtering and differential mode filtering capabilities while maintaining the current-carrying capacity of the busbar structure. The magnetic materials may attenuate high frequency currents generated by the power switching devices, thereby reducing electromagnetic interference and bearing currents in connected electric motors.

One or more embodiments may provide a simplified assembly process compared to traditional common mode choke implementations. The adhesive-based attachment of magnetic sheet materials may eliminate the need for complex mechanical assemblies, clamps, and precise fitting of ferrite cores around busbar structures. The magnetic sheets may be cut to size and applied during busbar assembly, reducing manufacturing complexity and improving packaging efficiency.

One or more embodiments may enable greater surface area coverage of busbar structures with magnetic material, providing enhanced electromagnetic interference attenuation compared to discrete common mode chokes. The magnetic materials may act as electromagnetic shields, attenuating radiated emissions from the busbar structures while simultaneously providing inductive filtering of common mode currents.

One or more embodiments may reduce the need for external common mode filtering components, thereby decreasing overall system volume and weight. The integrated magnetic filtering may allow for smaller inverter packaging while maintaining electromagnetic compatibility performance. The reduction in discrete filtering components may also improve mechanical reliability by eliminating vibration-prone external chokes.

One or more embodiments may provide filtering closer to the source of electromagnetic interference generation, specifically near the power switching devices where high frequency currents originate. This proximity may improve filtering effectiveness compared to remote filtering approaches and may reduce the propagation of electromagnetic interference through the power system.

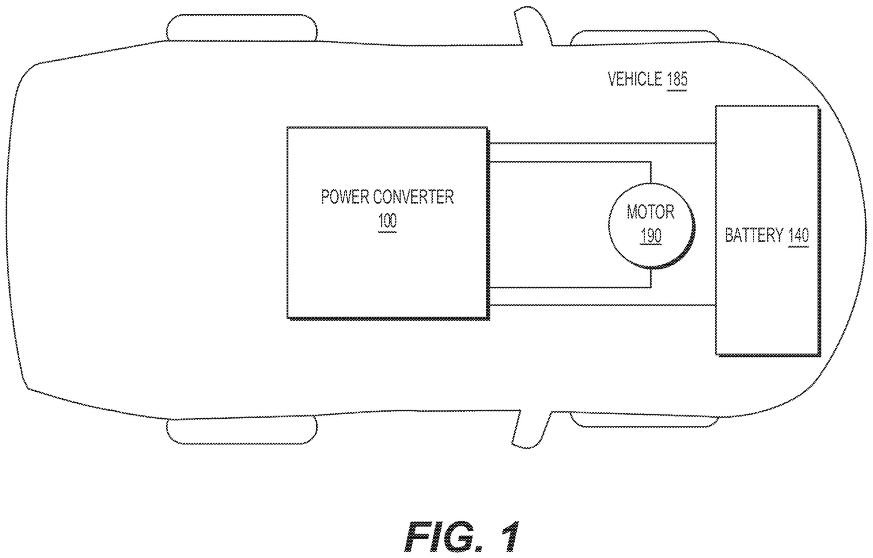

FIG. 1 depicts an exemplary system infrastructure for a vehicle including a power converter, according to one or more embodiments. The power converter 100 may be a combined inverter and converter. Alternatively, the inverter may be an inverter without a converter. In the context of this disclosure, a battery charger, the inverter, the converter, or any combination thereof may be referred to as power converter 100. Electric vehicle 185 may include power converter 100, motor 190, and battery 140. Power converter 100 may include components to receive electrical power from an external source and output electrical power to charge battery 140 of electric vehicle 185. Power converter 100 may convert DC power from battery 140 in electric vehicle 185 to AC power, to drive motor 190 of the electric vehicle 185, for example, but the embodiments are not limited thereto. For example, power converter 100 may include components to receive electrical power from an external source and output electrical power to charge battery 140 without motor 190 connected to power converter 100. Power converter 100 may convert DC power from battery 140 in electric vehicle 185 to AC power, to drive AC components other than motor 190 of the electric vehicle 185. Power converter 100 may be bidirectional, and may convert DC power to AC power, or convert AC power to DC power, such as during regenerative braking, for example. Power converter 100 may be a three-phase inverter, a single-phase inverter, or a multi-phase inverter.

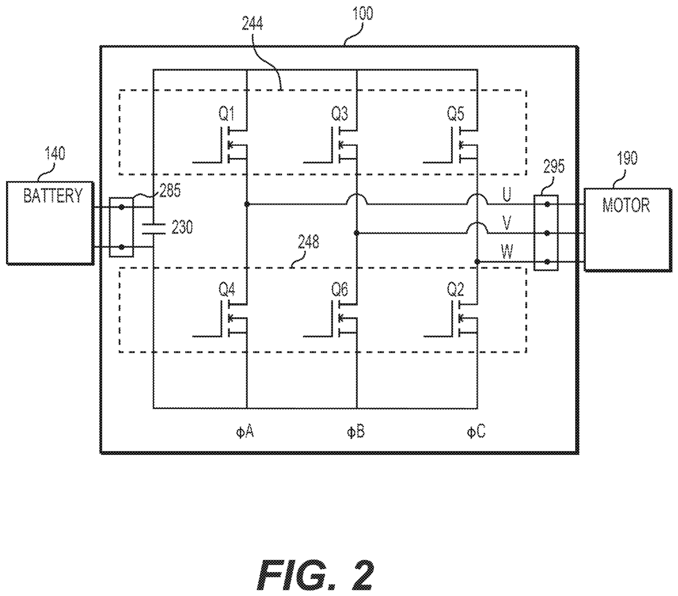

FIG. 2 depicts an exemplary system infrastructure for a power converter, according to one or more embodiments. Power converter 100 may be used to convert DC power from a battery in electric vehicle 185 to AC power, to drive motor 190 of electric vehicle 185, for example, but embodiments are not limited thereto. Additionally, power converter 100 may be bidirectional, and used to convert DC power to AC power, or to convert AC power to DC power.

Power converter 100 may be connected to battery 140 and motor 190. Power converter 100 may include upper phase switches 244 and lower phase switches 248. A first phase (ΦA) may include switches Q1 and Q4, a second phase (ΦB) may include switches Q3 and Q6, and a third phase (ΦC) may include switches Q5 and Q2. Upper phase switches 244 may include first phase switch Q1, second phase switch Q3, and third phase switch Q5. Lower phase switches 248 may include first phase switch Q4, second phase switch Q6, and third phase switch Q2. Switches Q1-Q6 may be metal-oxide-semiconductor field-effect transistors (MOSFET), for example, but embodiments are not limited thereto.

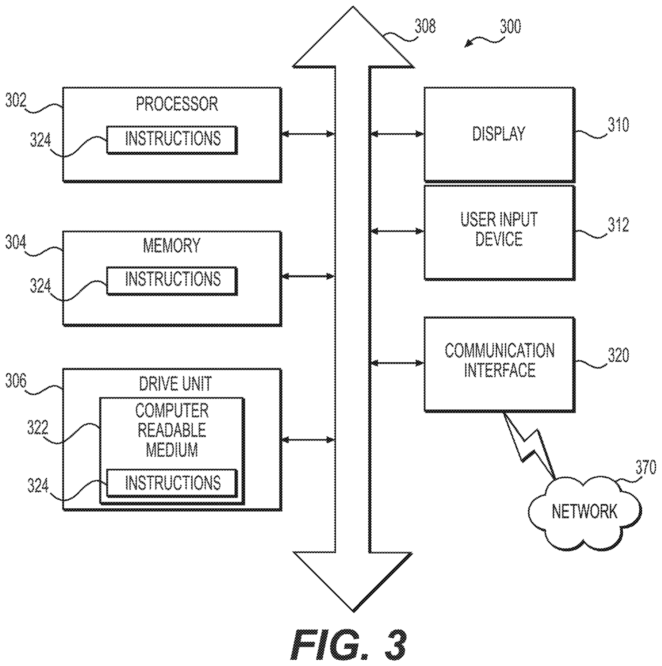

Upper phase switches 244 and lower phase switches 248 may be driven by a pulse width modulated (PWM) signal generated by controller 300 (e.g., see FIG. 3) to convert DC power delivered via the set of input terminals 285 at bulk capacitor 230 to three phase AC power at outputs U, V, and W (correlating with phases A, B, and C, respectively) via the set of output terminals 295 to motor 190. Additionally, although FIG. 2 depicts a three-phase inverter, the disclosure is not limited thereto, and may include single phase or multi-phase or multi-level inverters.

FIG. 3 depicts an exemplary system infrastructure for a controller, according to one or more embodiments. Controller 300 may include one or more controllers.

The controller 300 may include a set of instructions that can be executed to cause the controller 300 to perform any one or more of the methods or computer based functions disclosed herein. The controller 300 may operate as a standalone device or may be connected, e.g., using a network, to other computer systems or peripheral devices.

In a networked deployment, the controller 300 may operate in the capacity of a server or as a client in a server-client user network environment, or as a peer computer system in a peer-to-peer (or distributed) network environment. The controller 300 can also be implemented as or incorporated into various devices, such as a power converter, a personal computer (PC), a tablet PC, a set-top box (STB), a personal digital assistant (PDA), a mobile device, a palmtop computer, a laptop computer, a desktop computer, a communications device, a wireless telephone, a land-line telephone, a control system, a camera, a scanner, a facsimile machine, a printer, a pager, a personal trusted device, a web appliance, a network router, switch or bridge, or any other machine capable of executing a set of instructions (sequential or otherwise) that specify actions to be taken by that machine. In a particular implementation, the controller 300 can be implemented using electronic devices that provide voice, video, or data communication. Further, while the controller 300 is illustrated as a single system, the term "system" shall also be taken to include any collection of systems or sub-systems that individually or jointly execute a set, or multiple sets, of instructions to perform one or more computer functions.

As depicted in FIG. 3, the controller 300 may include a processor 302, e.g., a central processing unit (CPU), a graphics processing unit (GPU), or both. The processor 302 may be a component in a variety of systems. The processor 302 may be one or more general processors, digital signal processors, application specific integrated circuits, field programmable gate arrays, servers, networks, digital circuits, analog circuits, combinations thereof, or other now known or later developed devices for analyzing and processing data. The processor 302 may implement a software program, such as code generated manually (i.e., programmed).

The controller 300 may include a memory 304 that can communicate via a bus 308. The memory 304 may be a main memory, a static memory, or a dynamic memory. The memory 304 may include, but is not limited to computer readable storage media such as various types of volatile and non-volatile storage media, including but not limited to random access memory, read-only memory, programmable read-only memory, electrically programmable read-only memory, electrically erasable read-only memory, flash memory, magnetic tape or disk, optical media, and the like. In one implementation, the memory 304 includes a cache or random-access memory for the processor 302. In alternative implementations, the memory 304 is separate from the processor 302, such as a cache memory of a processor, the system memory, or other memory. The memory 304 may be an external storage device or database for storing data. Examples include a hard drive, compact disc ("CD"), digital video disc ("DVD"), memory card, memory stick, floppy disc, universal serial bus ("USB") memory device, or any other device operative to store data. The memory 304 is operable to store instructions executable by the processor 302. The functions, acts or tasks illustrated in the figures or described herein may be performed by the processor 302 executing the instructions stored in the memory 304. The functions, acts or tasks are independent of the particular type of instructions set, storage media, processor or processing strategy and may be performed by software, hardware, integrated circuits, firm-ware, micro-code, and the like, operating alone or in combination. Likewise, processing strategies may include multiprocessing, multitasking, parallel processing, and the like.

As depicted, the controller 300 may further include a display 310, such as a liquid crystal display (LCD), an organic light emitting diode (OLED), a flat panel display, a solid-state display, a cathode ray tube (CRT), a projector, a printer or other now known or later developed display device for outputting determined information. The display 310 may act as an interface for the user to see the functioning of the processor 302, or specifically as an interface with the software stored in the memory 304 or in the drive unit 306.

Additionally or alternatively, the controller 300 may include an input device 312 configured to allow a user to interact with any of the components of controller 300. The input device 312 may be a number pad, a keyboard, or a cursor control device, such as a mouse, or a joystick, touch screen display, remote control, or any other device operative to interact with the controller 300.

The controller 300 may also or alternatively include drive unit 306 implemented as a disk or optical drive. The drive unit 306 may include a computer-readable medium 322 in which one or more sets of instructions 324, e.g., software, can be embedded. Further, the instructions 324 may embody one or more of the methods or logic as described herein. The instructions 324 may reside completely or partially within the memory 304 and/or within the processor 302 during execution by the controller 300. The memory 304 and the processor 302 also may include computer-readable media as discussed above.

In some systems, a computer-readable medium 322 includes instructions 324 or receives and executes instructions 324 responsive to a propagated signal so that a device connected to a network 370 can communicate voice, video, audio, images, or any other data over the network 370. Further, the instructions 324 may be transmitted or received over the network 370 via a communication port or interface 320, and/or using a bus 308. The communication port or interface 320 may be a part of the processor 302 or may be a separate component. The communication port or interface 320 may be created in software or may be a physical connection in hardware. The communication port or interface 320 may be configured to connect with a network 370, external media, the display 310, or any other components in controller 300, or combinations thereof. The connection with the network 370 may be a physical connection, such as a wired Ethernet connection or may be established wirelessly as discussed below. Likewise, the additional connections with other components of the controller 300 may be physical connections or may be established wirelessly. The network 370 may alternatively be directly connected to a bus 308.

While the computer-readable medium 322 is depicted to be a single medium, the term "computer-readable medium" may include a single medium or multiple media, such as a centralized or distributed database, and/or associated caches and servers that store one or more sets of instructions. The term "computer-readable medium" may also include any medium that is capable of storing, encoding, or carrying a set of instructions for execution by a processor or that cause a computer system to perform any one or more of the methods or operations disclosed herein. The computer-readable medium 322 may be non-transitory, and may be tangible.

The computer-readable medium 322 can include a solid-state memory such as a memory card or other package that houses one or more non-volatile read-only memories. The computer-readable medium 322 can be a random-access memory or other volatile re-writable memory. Additionally or alternatively, the computer-readable medium 322 can include a magneto-optical or optical medium, such as a disk or tapes or other storage device to capture carrier wave signals such as a signal communicated over a transmission medium. A digital file attachment to an e-mail or other self-contained information archive or set of archives may be considered a distribution medium that is a tangible storage medium. Accordingly, the disclosure is considered to include any one or more of a computer-readable medium or a distribution medium and other equivalents and successor media, in which data or instructions may be stored.

In an alternative implementation, dedicated hardware implementations, such as application specific integrated circuits, programmable logic arrays and other hardware devices, can be constructed to implement one or more of the methods described herein. Applications that may include the apparatus and systems of various implementations can broadly include a variety of electronic and computer systems. One or more implementations described herein may implement functions using two or more specific interconnected hardware modules or devices with related control and data signals that can be communicated between and through the modules, or as portions of an application-specific integrated circuit. Accordingly, the present system encompasses software, firmware, and hardware implementations.

The controller 300 may be connected to a network 370. The network 370 may define one or more networks including wired or wireless networks. The wireless network may be a cellular telephone network, an 802.11, 802.16, 802.20, or WiMAX network. Further, such networks may include a public network, such as the Internet, a private network, such as an intranet, or combinations thereof, and may utilize a variety of networking protocols now available or later developed including, but not limited to TCP/IP based networking protocols. The network 370 may include wide area networks (WAN), such as the Internet, local area networks (LAN), campus area networks, metropolitan area networks, a direct connection such as through a Universal Serial Bus (USB) port, or any other networks that may allow for data communication. The network 370 may be configured to couple one computing device to another computing device to enable communication of data between the devices. The network 370 may generally be enabled to employ any form of machine-readable media for communicating information from one device to another. The network 370 may include communication methods by which information may travel between computing devices. The network 370 may be divided into sub-networks. The sub-networks may allow access to all of the other components connected thereto or the sub-networks may restrict access between the components. The network 370 may be regarded as a public or private network connection and may include, for example, a virtual private network or an encryption or other security mechanism employed over the public Internet, or the like.

In accordance with various implementations of the present disclosure, the methods described herein may be implemented by software programs executable by a computer system. Further, in an exemplary, non-limited implementation, implementations can include distributed processing, component or object distributed processing, and parallel processing. Alternatively, virtual computer system processing can be constructed to implement one or more of the methods or functionality as described herein.

Although the present specification describes components and functions that may be implemented in particular implementations with reference to particular standards and protocols, the disclosure is not limited to such standards and protocols. For example, standards for Internet and other packet switched network transmission (e.g., TCP/IP, UDP/IP, HTML, HTTP) represent examples of the state of the art. Such standards are periodically superseded by faster or more efficient equivalents having essentially the same functions. Accordingly, replacement standards and protocols having the same or similar functions as those disclosed herein are considered equivalents thereof.

It will be understood that the operations of methods discussed are performed in one embodiment by an appropriate processor (or processors) of a processing (i.e., computer) system executing instructions (computer-readable code) stored in storage. It will also be understood that the disclosure is not limited to any particular implementation or programming technique and that the disclosure may be implemented using any appropriate techniques for implementing the functionality described herein. The disclosure is not limited to any particular programming language or operating system.

One or more embodiments of the disclosure may provide a busbar structure with integrated magnetic filtering that reduces common mode currents without requiring bulky external common mode chokes. Some approaches for addressing common mode currents in electric vehicle power systems may use discrete common mode chokes that are positioned externally to the busbar assembly. These approaches may require complex mechanical assemblies where ferrite cores must be fitted around existing busbar structures, often requiring the core to slide over complex busbar assemblies during manufacturing. These approaches may result in large volume requirements, mechanical vibration issues, and manufacturing challenges due to the need for clamps and adhesives to secure the ferrite cores. Some approaches may require complex fabrication processes including cleaning, sputtering, electroplating, masking, etching, and cutting to integrate magnetic materials with bus structures. These approaches may not effectively address common mode currents at their source near the switching devices, and may not provide adequate surface area coverage of the bus structure for optimal electromagnetic interference attenuation.

One or more embodiments may solve the problem of common mode current generation and electromagnetic interference by integrating flexible magnetic sheet materials directly into modular busbar structures using adhesive attachment methods. One or more embodiments may provide magnetic sheet materials, such as ferrite or nanocrystalline materials, which can be applied as adhesive layers to busbar structures. The magnetic materials may be configured in multiple arrangements including interleaved configurations between positive and negative busbar layers, wrapped configurations around the exterior of busbar assemblies, or combinations of both interleaved and wrapped configurations. The flexible nature of the magnetic sheet materials may allow for conforming to complex busbar geometries while providing electromagnetic filtering functionality.

One or more embodiments may reduce the loop area for common mode currents by interleaving magnetic materials between alternating positive and negative busbar layers. The interleaved arrangement may provide both common mode filtering and differential mode filtering capabilities while maintaining the current-carrying capacity of the busbar structure. The magnetic materials may attenuate high frequency currents generated by the power switching devices, thereby reducing electromagnetic interference and bearing currents in connected electric motors.

One or more embodiments may provide a simplified assembly process compared to traditional common mode choke implementations. The adhesive-based attachment of magnetic sheet materials may eliminate the need for complex mechanical assemblies, clamps, and precise fitting of ferrite cores around busbar structures. The magnetic sheets may be cut to size and applied during busbar assembly, reducing manufacturing complexity and improving packaging efficiency.

One or more embodiments may enable greater surface area coverage of busbar structures with magnetic material, providing enhanced electromagnetic interference attenuation compared to discrete common mode chokes. The magnetic materials may act as electromagnetic shields, attenuating radiated emissions from the busbar structures while simultaneously providing inductive filtering of common mode currents.

One or more embodiments may reduce the need for external common mode filtering components, thereby decreasing overall system volume and weight. The integrated magnetic filtering may allow for smaller inverter packaging while maintaining electromagnetic compatibility performance. The reduction in discrete filtering components may also improve mechanical reliability by eliminating vibration-prone external chokes.

One or more embodiments may provide filtering closer to the source of electromagnetic interference generation, specifically near the power switching devices where high frequency currents originate. This proximity may improve filtering effectiveness compared to remote filtering approaches and may reduce the propagation of electromagnetic interference through the power system.

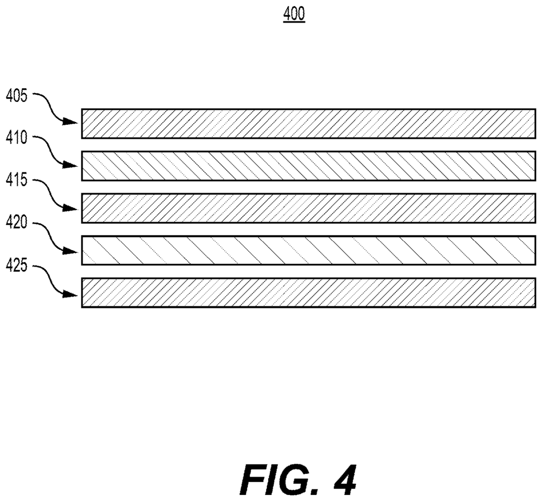

FIG. 4 depicts an exemplary busbar structure 400, according to one or more embodiments. Referring to FIG. 4, busbar structure 400 may include multiple layers arranged in a stacked configuration. The busbar structure 400 may comprise a first magnetic layer 405 positioned at a top portion of the structure. A positive connector 410 may be positioned below the first magnetic layer 405 and may serve as a conductive element for carrying positive direct current voltage. The positive connector 410 may function as a first direct current connector within the busbar structure 400. Busbar structure 400 may be a direct current (DC) busbar.

A second magnetic layer 415 may be positioned beneath the positive connector 410, creating an interleaved arrangement between the magnetic material and the conductive elements. The second magnetic layer 415 may be positioned between the positive connector 410 and additional conductive layers. A negative connector 420 may be positioned below the second magnetic layer 415 and may serve as a conductive element for carrying negative direct current voltage. The negative connector 420 may function as a second direct current connector within the busbar structure 400.

A third magnetic layer 425 may be positioned at a bottom portion of the busbar structure 400, beneath the negative connector 420. The third magnetic layer 425 may complete the layered arrangement and may provide additional magnetic shielding properties. The alternating arrangement of the first magnetic layer 405, second magnetic layer 415, and third magnetic layer 425 with the positive connector 410 and negative connector 420 may create an interleaved configuration that enables both common mode and differential mode filtering.

The first magnetic layer 405, second magnetic layer 415, and third magnetic layer 425 may be made from ferrite material or nanocrystalline material, providing flexibility in material selection for different magnetic properties. The ferrite material may provide soft magnetic characteristics suitable for high-frequency filtering applications. The nanocrystalline material may offer enhanced magnetic permeability and may be particularly effective for attenuating electromagnetic interference.

The disclosure is not limited to an arrangement including three magnetic layers, and busbar structure 400 may employ a greater or fewer number of magnetic layers. The magnetic layers may be interleaved between the positive connector 410 and negative connector 420 to enable both common mode and differential mode filtering. The first magnetic layer 405 may be positioned between the positive connector 410 and an external environment, while the second magnetic layer 415 may be positioned directly between the positive connector 410 and the negative connector 420. The third magnetic layer 425 may be positioned between the negative connector 420 and the external environment, enabling a comprehensive magnetic shielding arrangement. Further, although specific orientations and positions of the positive and negative connectors are shown in the figures, such configurations are exemplary only, and the connectors may be arranged in any order or orientation suitable for a given implementation.

The first magnetic layer 405, second magnetic layer 415, and third magnetic layer 425 may provide electromagnetic interference shielding by creating a magnetic shield around the busbar structure 400. The magnetic layers may attenuate radiated emissions emanating from the positive connector 410 and negative connector 420, reducing electromagnetic interference in surrounding systems. The magnetic shield made from ferrous material may be particularly effective at containing high-frequency electromagnetic fields generated by switching operations in power electronic systems.

The busbar structure 400 may reduce loop area for common mode currents by enabling closer spacing of the positive connector 410 and negative connector 420. The interleaved arrangement may minimize the physical separation between positive and negative current paths, thereby reducing the enclosed area through which common mode currents may flow. The reduced loop area may result in decreased parasitic inductance and improved electromagnetic compatibility.

The first magnetic layer 405, second magnetic layer 415, and third magnetic layer 425 may be configured to attenuate high frequency currents from the positive connector 410 and the negative connector 420. The magnetic material may present increased impedance to high-frequency current components while allowing low-frequency and direct current components to pass with minimal attenuation. The magnetic layers may function as distributed inductors that suppress high-frequency noise and switching transients.

The first magnetic layer 405, second magnetic layer 415, and third magnetic layer 425 may include adhesive material that enables attachment to the positive connector 410 and negative connector 420. The adhesive material may provide mechanical bonding between the magnetic layers and the conductive elements, eliminating the need for mechanical fasteners or complex assembly procedures. The adhesive attachment may maintain electrical isolation between the magnetic material and the current-carrying conductors while ensuring reliable mechanical connection.

The busbar structure 400 may include a flexible busbar configuration that allows for conforming to various geometric requirements. The flexible nature of the structure may enable installation in confined spaces and may accommodate thermal expansion and mechanical vibration. The busbar structure 400 may include a modular design that allows for scalable implementation in different power converter applications.

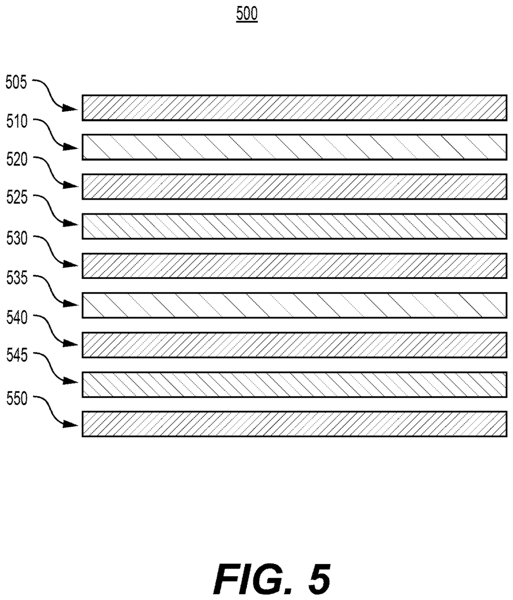

FIG. 5 depicts an exemplary interleaved DC link bus structure 500, according to one or more embodiments. As depicted in FIG. 5, interleaved DC link bus structure 500 may provide enhanced electromagnetic filtering capabilities through an alternating arrangement of magnetic layers and conductive elements. The interleaved DC link bus structure 500 may comprise multiple magnetic layers and direct current connectors arranged in a stacked configuration that enables both common mode filtering and differential mode filtering.

As shown in FIG. 5, the interleaved DC link bus structure 500 may include a first magnetic layer 505 positioned at a top portion of the assembly. The first magnetic layer 505 may comprise a ferrite material or a nanocrystalline structure that provides magnetic properties for filtering high frequency currents. The first magnetic layer 505 may include an adhesive material that facilitates attachment to adjacent components within the busbar stack.

A first negative connector 510 may be positioned beneath the first magnetic layer 505. The first negative connector 510 may serve as a direct current connector that carries negative voltage within the power converter system. The first negative connector 510 may be attached to the first magnetic layer 505 through one or more adhesives that provide secure bonding between the conductive and magnetic elements.

The interleaved DC link bus structure 500 may further include a second magnetic layer 520 positioned beneath the first negative connector 510. The second magnetic layer 520 may comprise similar magnetic materials as the first magnetic layer 505 and may be configured to attenuate high frequency currents from the first negative connector 510. The second magnetic layer 520 may include adhesive properties that enable attachment to the surrounding conductive elements.

A first positive connector 525 may be positioned beneath the second magnetic layer 520. The first positive connector 525 may function as a positive direct current connector that carries positive voltage within the DC busbar system. The first positive connector 525 may be secured to the second magnetic layer 520 through adhesive bonding that maintains the structural integrity of the interleaved arrangement.

With continued reference to FIG. 5, a third magnetic layer 530 may be positioned beneath the first positive connector 525. The third magnetic layer 530 may provide additional magnetic filtering capabilities and may comprise ferrite material or nanocrystalline structures. The third magnetic layer 530 may be configured to shield the first positive connector 525 and may include adhesive material for attachment to adjacent layers.

A second negative connector 535 may be positioned beneath the third magnetic layer 530. The second negative connector 535 may serve as another direct current connector for negative voltage transmission within the modular DC busbar system. The alternating arrangement of positive and negative connectors may reduce loop area for common mode currents and enhance the filtering performance of the interleaved DC link bus structure 500.

The interleaved DC link bus structure 500 may also include a fourth magnetic layer 540 positioned beneath the second negative connector 535. The fourth magnetic layer 540 may provide magnetic shielding and filtering properties similar to the other magnetic layers within the assembly. The fourth magnetic layer 540 may be attached to the second negative connector 535 through adhesive bonding.

A second positive connector 545 may be positioned beneath the fourth magnetic layer 540. The second positive connector 545 may function as an additional positive direct current connector within the busbar stack. The second positive connector 545 may be part of the flexible busbar configuration that enables the interleaved arrangement of conductive and magnetic elements.

As further shown in FIG. 5, a fifth magnetic layer 550 may be positioned at a bottom portion of the interleaved DC link bus structure 500, beneath the second positive connector 545. The fifth magnetic layer 550 may complete the alternating arrangement of magnetic and conductive layers within the busbar stack. The fifth magnetic layer 550 may include ferrite material or nanocrystalline structures and may be configured for both common mode filtering and differential mode filtering applications.

The alternating arrangement of the first magnetic layer 505, second magnetic layer 520, third magnetic layer 530, fourth magnetic layer 540, and fifth magnetic layer 550 with the first negative connector 510, first positive connector 525, second negative connector 535, and second positive connector 545 may create a high voltage DC busbar system with enhanced electromagnetic compatibility. The interleaved configuration may reduce parasitic capacitances and provide increased surface area coverage of magnetic material relative to the conductive busbar elements, thereby improving the attenuation of common mode and differential mode currents within the power converter system.

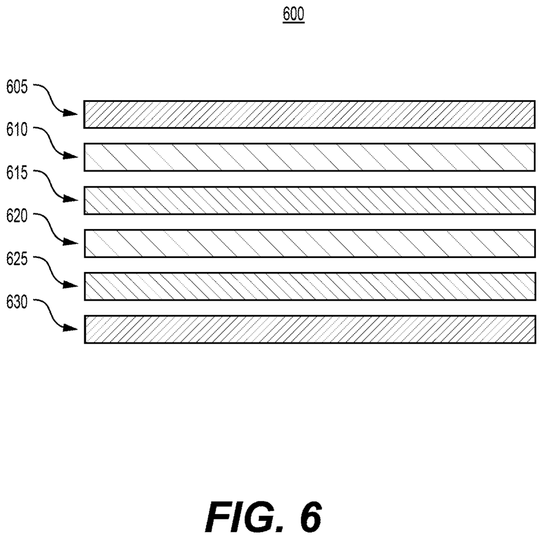

FIG. 6 depicts an exemplary interleaved bus structure, according to one or more embodiments. As depicted in FIG. 6, interleaved bus structure 600 may include multiple conductive layers arranged in an alternating configuration with magnetic material layers positioned around the assembly. The interleaved bus structure 600 may comprise a first magnetic layer 605 positioned at a top portion of the assembly. A first negative connector 610 may be positioned below the first magnetic layer 605 and may serve as a conductive element for carrying negative direct current. A first positive connector 615 may be positioned beneath the first negative connector 610 and may serve as a conductive element for carrying positive direct current. A second negative connector 620 may be positioned beneath the first positive connector 615 and may provide additional negative direct current connectivity. A second positive connector 625 may be positioned beneath the second negative connector 620 and may provide additional positive direct current connectivity. A second magnetic layer 630 may be positioned at a bottom portion of the assembly. An insulating material may be located between the positive connectors and the negative connectors.

The first negative connector 610, first positive connector 615, second negative connector 620, and second positive connector 625 may form interleaved busbar layers that carry electrical current in the interleaved bus structure 600. The interleaved arrangement of the negative and positive connectors may reduce loop area for common mode currents flowing through the system. The first magnetic layer 605 and second magnetic layer 630 may provide magnetic shielding and filtering properties to attenuate common mode currents flowing through the interleaved bus structure 600.

The magnetic layers may wrap around the conductive layers to, for example, provide enhanced electromagnetic interference suppression. The first magnetic layer 605 may be wrapped around portions of the first negative connector 610 and first positive connector 615. Similarly, the second magnetic layer 630 may wrap around portions of the second negative connector 620 and second positive connector 625. The wrapping configuration may enable the magnetic material to surround the conductive elements and provide increased surface area coverage for improved attenuation of high-frequency currents.

In some cases, multiple layers of magnetic material may be wrapped around the busbar structure to provide increased attenuation of common mode currents. The magnetic shielding sheet may be applied in successive wrapping layers, with each additional layer contributing to the overall inductance and filtering capability of the interleaved bus structure 600. The multi-layer wrapping aspect may enable customization of the filtering characteristics based on the specific electromagnetic interference requirements of the application.

The interleaved bus structure 600 may function as a high voltage DC busbar in power conversion applications. The first positive connector 615 and second positive connector 625 may serve as positive direct current connectors, while the first negative connector 610 and second negative connector 620 may serve as negative direct current connectors. The interleaved bus structure 600 may include a flexible busbar configuration that allows for adaptable routing and installation in various system configurations.

The first magnetic layer 605 may be attached to the first negative connector 610 with an adhesive material. The second magnetic layer 630 may be attached to second positive connector 625 with an adhesive material. The adhesive attachment may enable secure bonding between the magnetic materials and the conductive elements without requiring complex mechanical fastening systems.

The interleaved bus structure 600 may comprise a modular DC busbar that can be integrated into various power converter configurations. The modular design may allow for scalable implementation based on current carrying requirements and electromagnetic compatibility specifications. The alternating arrangement of positive and negative connectors with interleaved magnetic layers may provide both current carrying capability and integrated filtering functionality within a single busbar assembly. Interleaved bus structure 600 may provide for CM filtering. Each layer of interleaved bus structure 600 may be attached to an adjacent structure by one or more adhesives.

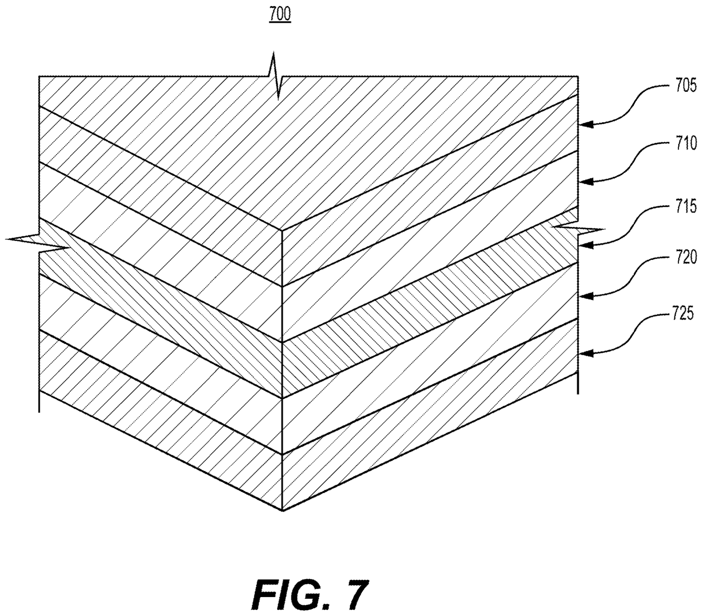

FIG. 7 depicts an exemplary magnetic shielding sheet, according to one or more embodiments. As depicted in FIG. 7, a magnetic shielding sheet 700 may be constructed with multiple layers to provide both magnetic properties and adhesive attachment capabilities. The magnetic shielding sheet 700 may comprise a protective film layer 705 positioned at a top surface of the structure. A first adhesive layer 710 may be disposed beneath the protective film layer 705 to facilitate bonding between adjacent components. A layer 715 may be positioned beneath the first adhesive layer 710 and may form a core magnetic component of the magnetic shielding sheet 700. A second adhesive layer 720 may be located below the layer 715 to provide additional bonding functionality. A second protective film layer 725 may be positioned at a bottom surface of the magnetic shielding sheet 700 to provide lower surface protection.

The layer 715 may include a ferrite material that provides magnetic properties for electromagnetic interference suppression and common mode current attenuation. In some cases, the layer 715 may include a nanocrystalline structure that offers enhanced magnetic permeability and frequency response characteristics. The ferrite material or nanocrystalline structure may be the same type of material found in wireless phone chargers, leveraging existing magnetic material technology for power electronic applications.

The first adhesive layer 710 and the second adhesive layer 720 may enable the magnetic shielding sheet 700 to be attached to busbar structures without requiring complex assembly processes. The first adhesive layer 710 may bond the layer 715 to the protective film layer 705, while the second adhesive layer 720 may facilitate attachment of the magnetic shielding sheet 700 to conductive components such as direct current connectors. The adhesive layers may eliminate the need for mechanical fasteners or complex manufacturing processes such as cleaning, sputtering, electroplating, masking, etching, and cutting.

The protective film layer 705 and the second protective film layer 725 may provide isolation and protection during handling and installation of the magnetic shielding sheet 700. When the magnetic shielding sheet 700 includes conductive magnetic materials, a busbar structure may be overmolded to provide additional isolation between the magnetic material and the conductive elements. The overmolding process may ensure electrical isolation while maintaining the magnetic properties of the layer 715. Protective film layer 705 or second protective film layer 725 may be removable.

The magnetic shielding sheet 700 may be cut for custom applications. This approach may allow for flexible sizing and shaping of the magnetic shielding sheet 700 to accommodate various busbar configurations and packaging requirements. The magnetic shielding sheet 700 may be configured to shield direct current connectors by providing electromagnetic attenuation and reducing radiated emissions from high-current busbar structures.

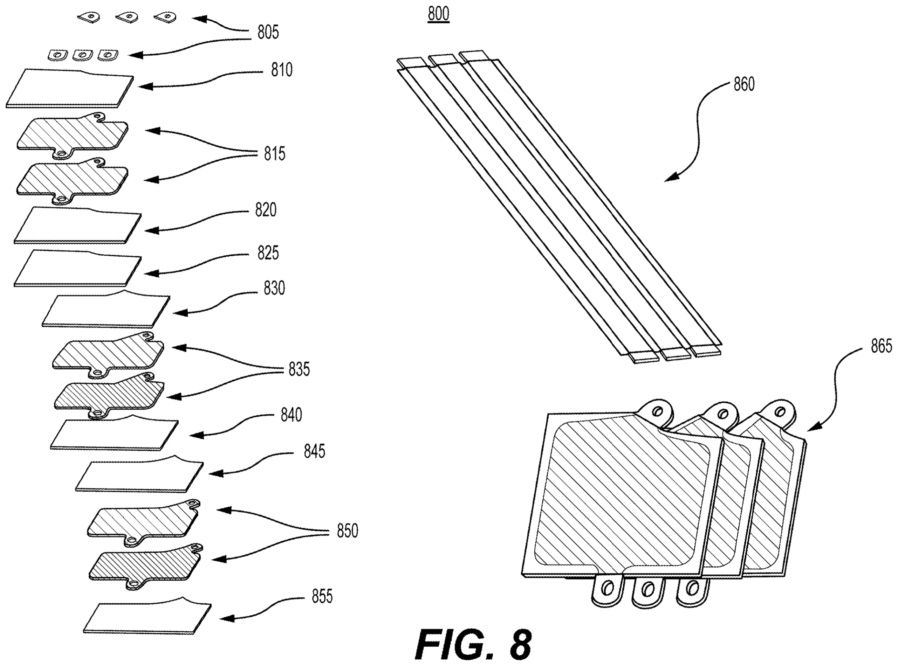

FIG. 8 depicts an exemplary composite structure 800, according to one or more embodiments. As depicted in FIG. 8, composite structure 800 may include lugs 805 positioned at one end for connection purposes. The composite structure 800 may comprise multiple sections 865 that are assembled together to form the overall structure. The lugs 805 may provide mechanical connection points for integrating the composite structure 800 with other components in an assembly. Lugs 805 may be welded of soldered.

The composite structure 800 may include a layered arrangement of adhesive materials and phase materials. A first adhesive layer 810 may bond to a first phase material 815. The first phase material 815 may comprise a conductive material configured to carry electrical current. A second adhesive layer 820 may connect the first phase material 815 to a pressure sensitive adhesive 825. The pressure sensitive adhesive 825 may provide bonding capability that activates under applied pressure.

A third adhesive layer 830 may bond the pressure sensitive adhesive 825 to a second phase material 835. The second phase material 835 may comprise a conductive material similar to the first phase material 815. A fourth adhesive layer 840 may be positioned adjacent to the second phase material 835. The structure may continue with a fifth adhesive layer 845 connecting to a third phase material 850. The third phase material 850 may comprise a conductive material configured for electrical connectivity. A sixth adhesive layer 855 may complete the layered assembly of the composite structure 800.

The adhesive material of one or more of adhesive layer 810, second adhesive layer 820, third adhesive layer 830, fourth adhesive layer 840, fifth adhesive layer 845, or sixth adhesive layer 855 may the same adhesive material or a different adhesive material as the remaining adhesive layers. First phase material 815, second phase material 835, and third phase material 850 may include one or more layers of phase material. First phase material 815, second phase material 835, and third phase material 850 may be from approximately 0.10 mm to approximately 0.3 mm each. For example, the phase material layers may be 0.25 mm. Each phase material layer may have the same or different thickness.

The composite structure 800 may be configured for AC phase applications where alternating current flows through the phase materials. In such applications, the first phase material 815, second phase material 835, and third phase material 850 may carry different AC phases or may provide redundant current paths for a single AC phase. The magnetic properties of the adhesive layers may provide common mode filtering and differential mode filtering for AC signals flowing through the phase materials.

The composite structure 800 may also be applied to PCB routed systems for common mode current reduction. In PCB applications, the composite structure 800 may be integrated with printed circuit board traces to provide magnetic shielding and filtering. The flexible nature of the adhesive layers may allow the composite structure 800 to conform to PCB surface topography and provide effective electromagnetic interference suppression.

The multiple sections 865 of the composite structure 800 may allow modular assembly configurations, such as bars 860. Each section may be independently manufactured and subsequently assembled to create the complete composite structure 800. The modular approach may enable customization of the composite structure 800 for specific application requirements, such as varying current ratings or different phase configurations.

One or more embodiments may provide a single layer magnetic material wound around the bus and attached with an adhesive. The single layer of magnetic material may comprise one or more sublayers of magnetic material. Some solutions to the problems with implementing common mode chokes include the use of clamps and glue to keep the core of the choke together. Single piece cores are difficult to manufacture, since the core must slide over complex busbar assemblies, increasing design cost. Some solutions use a grounding ring on the motor shaft to reduce the common mode currents.

One or more embodiments may layer and interleave magnetic material within a bus structure. Layering and interleaving magnetic material may allow for decreasing the loop area and provide more inductance to reduce the common mode currents in the system.

One or more embodiments may cover the surface area of the bus structure with magnetic material which may provide more attenuation. High frequency currents may be attenuated by the magnetic material, leading to better EMI performance and less high frequency currents. The magnetic material may be a single layer or composed of multiple layers of magnetic materials.

One or more embodiments may provide magnetic materials within an interleaved bus structure. The magnetic material layers may provide for increased inductance. The magnetic materials may be interleaved for both common mode (CM) and differential mode (DM) filtering. One or more embodiments may provide an interleaved bus structure wrapped with the magnetic material. One or more embodiments may use a flexible bus structure in an inverter. Some methods to create the filter require a complex process that includes cleaning, sputtering, electroplating, masking, etching, and cutting. One or more embodiments may use an adhesive technology to simplify the assembly process.

One or more embodiments may provide simpler busbar routing and decreased inverter volume, as a large choke may not be needed. Mechanical implementation may be simpler since vibrations during use would be less of an issue. Adhesives may be used, simplifying manufacturing and increasing mechanical stability. The ferrite materials may act as a shield as well, since it would attenuate radiated emissions coming from the busbar. Common mode currents may be reduced closer to the switches, where noise is generated. The magnetic material may be placed close to the AC busbars and through the motor, which may reduce the need for ceramic bearings or connecting the shaft to ground.

One or more embodiments may reduce common mode noise by wrapping the busbar filtration with a single winding common mode filter. The single winding common mode filter may include one or more magnetic materials. One or more embodiments may employ a modular bus structure to integrate a portion of a common mode filter into the busbar structure by using magnetic sheet material.

One or more embodiments may be used with PCB routed systems. One or more embodiments may reduce the common mode loop area by leveraging one or more magnetic materials with one or more interleaved busbars. One or more embodiments may provide for creating a common mode filter and a differential mode filter by manufacturing one or more ferrite sheets between the busbar layers in order to create a common mode filter and differential mode filter. One or more embodiments may wrap busbars with the ferrite sheets to provide additional attenuation. Interleaving may reduce parasitic capacitances in the system.

One or more embodiments may reduce the amount of copper from a DC input to a DC link capacitor by interleaving. Interleaving may reduce the loop area for CM currents. One or more embodiments may reduce the size of the external CM filter. For example, wrapping the interleaving layers around the busbar may reduce the size of the external CM filter and improve packaging of the DC filter. One or more embodiments may use one or more adhesives to attach the material to a bus structure. One or more embodiments may not require one or more of a cleaning, a sputtering, an electroplating, a masking, an etching, or a cutting process. One or more embodiments may increase attenuation by layering magnetic materials. Layering magnetic materials may provide for magnetic emissions attenuation by creating a ferrous shield (part of EMI challenges).

One or more embodiments may provide integrated magnetic filtering within busbar structures that eliminates the need for bulky external common mode chokes and reduces overall system volume and packaging constraints. One or more embodiments may simplify assembly processes by using adhesive-based attachment of magnetic sheet materials, eliminating complex mechanical assemblies, clamps, and precise fitting requirements associated with traditional ferrite core implementations. One or more embodiments may reduce common mode currents and electromagnetic interference by positioning magnetic filtering closer to the source of noise generation near power switching devices, improving filtering effectiveness compared to remote filtering approaches. One or more embodiments may provide enhanced surface area coverage of busbar structures with magnetic material, delivering superior electromagnetic interference attenuation and shielding performance compared to discrete common mode chokes.

One or more embodiments may reduce loop area for common mode currents through interleaved arrangements of positive and negative busbar layers with magnetic materials, decreasing parasitic inductance and improving electromagnetic compatibility. One or more embodiments may attenuate high frequency currents and switching transients through distributed magnetic inductance integrated directly within the busbar assembly, reducing bearing currents in electric motors and preventing premature bearing failure. One or more embodiments may enable flexible and modular busbar configurations that conform to complex geometries while maintaining current-carrying capacity and providing both common mode and differential mode filtering capabilities. One or more embodiments may improve mechanical reliability by eliminating vibration-prone external chokes and reducing the number of discrete filtering components required in electric vehicle power systems.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

## Claims

1. A system comprising a power converter, the power converter including:
a direct current (DC) busbar including:
a first magnetic layer;
a second magnetic layer;
a third magnetic layer;
a first direct current connector between the first magnetic layer and the second magnetic layer; and
a second direct current connector between the second magnetic layer and the third magnetic layer.

2. The system of claim 1, wherein the DC busbar is a high voltage DC busbar.

3. The system of any one of claims 1 to 2, wherein the first magnetic layer and the third magnetic layer are wrapped around the first direct current connector and the second direct current connector.

4. The system of any one of claims 1 to 3, wherein the first direct current connector is a positive direct current connector and the second direct current connector is a negative direct current connector.

5. The system of any one of claims 1 to 4, wherein one or more of the first magnetic layer, the second magnetic layer, or the third magnetic layer includes an adhesive material; and/or
wherein one or more of the first magnetic layer, the second magnetic layer, or the third magnetic layer is configured to attenuate high frequency currents from one or more of the first direct current connector or the second direct current connector.

6. The system of any one of claims 1 to 5, wherein the DC busbar includes a flexible busbar; and/or
wherein the DC busbar includes a modular DC busbar.

7. The system of any one of claims 1 to 6, wherein one or more of the first magnetic layer, the second magnetic layer, or the third magnetic layer includes a ferrite material.

8. The system of any one of claims 1 to 7, further comprising:
a battery; and
a motor connected to one or more of the motor or the power converter,
wherein the battery, the motor, and the power converter are provided as a vehicle.

9. A busbar stack comprising:
a first magnetic layer;
a second magnetic layer;
a third magnetic layer;
a fourth magnetic layer;
a fifth magnetic layer;
a first direct current connector between the first magnetic layer and the second magnetic layer;
a second direct current connector between the second magnetic layer and the third magnetic layer;
a third direct current connector between the third magnetic layer and the fourth magnetic layer; and
a fourth direct current connector between the fourth magnetic layer and the fifth magnetic layer.

10. The busbar stack of claim 9, wherein one or more of the first magnetic layer, the second magnetic layer, the third magnetic layer, the fourth magnetic layer, or the fifth magnetic layer includes a nanocrystalline structure; and/or
wherein one or more of the first magnetic layer, the second magnetic layer, the third magnetic layer, the fourth magnetic layer, or the fifth magnetic layer includes a ferrite material.

11. The busbar stack of any one claims 9 to 10, wherein one or more of the first magnetic layer, the second magnetic layer, the third magnetic layer, the fourth magnetic layer, the fifth magnetic layer, the first direct current connector, the second direct current connector, the third direct current connector, or the fourth direct current connector is attached to an adjacent structure by one or more adhesives.

12. The busbar stack of any one claims 9 to 11, wherein the busbar stack is configured for one or more of common mode filtering or differential mode filtering.

13. A busbar comprising:
a first magnetic layer;
a second magnetic layer;
a first direct current connector between the first magnetic layer and the second magnetic layer; and
a second direct current connector between the first magnetic layer and the second magnetic layer.

14. The busbar of claim 13, further comprising:
a third direct current connector between the first magnetic layer and the second magnetic layer; and
a fourth direct current connector between the first magnetic layer and the second magnetic layer;
and/or further comprising:
a third magnetic layer between the first direct current connector and the second direct current connector.

15. The busbar of claim 16, wherein the first magnetic layer is attached to the first direct current connector with an adhesive;
and wherein, preferably, the first magnetic layer is configured to shield the first direct current connector.
